# EUROPEAN PATENT SPECIFICATION

(11) **EP 1 992 716 B1**
(45) Date of publication and mention of the grant of the patent: **24.04.2013**
(21) Application number: 07720303.2
(22) Date of filing: 02.03.2007
(51) Int. Cl.: F24J 2/48, C23C 14/24, C23C 14/06

(54) **LIGHT SELECTIVELY ABSORBING LAYERS AND METHOD FOR MAKING THE SAME**
LICHT SELEKTIV ABSORBIERENDE SCHICHTEN UND HERSTELLUNGSVERFAHREN DAFÜR
COUCHES À ABSORPTION SÉLECTIVE DE LUMIÈRE ET LEUR PROCÉDÉ DE FABRICATION

(30) Priority: 03.03.2006 CN 200610058732; 03.03.2006 CN 200610058731
(43) Date of publication of application: 19.11.2008
(73) Proprietor: Shenzhen Commonpraise Solar Co., Ltd, Shenzhen, Guangdong 518118 (CN)
(72) Inventor: YIN, Zhiquiang, Beijing 100084 (CN)
(74) Representative: Goddar, Heinz J.
(86) International application number: PCT/CN2007/000668
(87) International publication number: WO 2007/098708

(56) References cited:
- CN-A- 1 159 553
- CN-A- 1 584 445
- US-A- 4 339 484
- US-A- 5 501 780
- US-A- 5 523 132

## Description

### TECHNICAL FIELD

The present invention relates to a light selective absorbing coating and a production process thereof. The light selective absorbing coating consists of a composite material film deposited by reaction of iron chromium alloy and a non-metal gas with vacuum deposition technology. Said non-metal gas is preferably a gas comprising nitrogen and oxygen elements. The present invention also relates to a solar energy heat collecting element or solar energy selective absorbing coating system comprising said light selective absorbing coating and a production process thereof. The present invention further relates to use of said composite material films as a light selective absorbing coating of a solar energy heat collecting element or of a solar energy selective absorbing coating system.

### BACKGROUND ART

Light selective absorbing coatings are core functional parts in light absorptive systems for absorbing light energy. They are usually applied in solar energy heat collecting elements or solar energy selective absorbing coating systems.

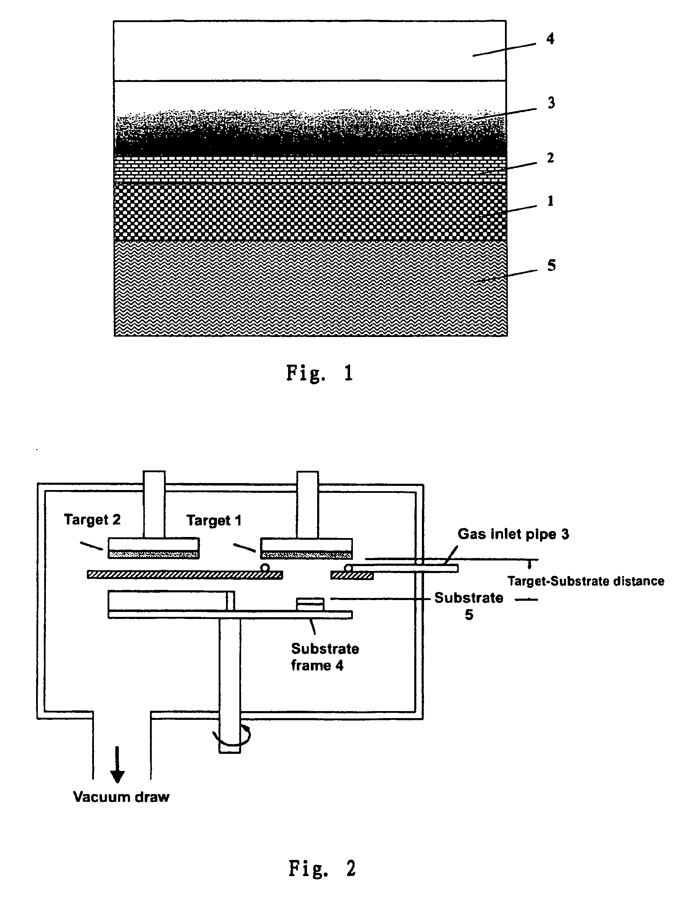

A solar energy heat collecting element consists of a substrate and a solar energy selective absorbing coating system. Solar energy selective absorbing coating system is a group of film system having multilayer structures, as shown in Fig. 1, it comprises a high infrared reflective base layer 1 attached on the surface of the substrate 5, an optional buffer layer2, a light selective absorbing layer 3 (an absorbing layer for short in the present application) and an anti-reflection film layer 4 (an anti-reflection layer for short in the present application).

Solar energy selective absorbing coating systems convert solar light energy into heat energy, and thus the temperature of the coating systems and the substrates are increased. The coating systems radiate energy to environment in the form of infrared heat wave due to temperature themselves to thereby loss energy. Therefore, it is requested that solar energy selective absorbing coating systems can absorb the part of energy concentration in solar energy spectrum received aground and radiate less infrared heat wave to the environment.

The term "selective" in "solar energy selective absorbing coating systems" and "light selective absorbing coatings" means that the light absorbing characteristics of the coating system have selectivity to spectrum, that is, having high solar absorptance α value in solar energy spectrum wavelength 0.3-3.0 µm and having low infrared emittance ε value in infrared spectrum range.

Solar absorptance α and infrared emittance ε are two important light heat property indexes of the solar energy selective absorbing coating systems, in which the solar absorptance α depends on the selection of an absorbing coating and an anti-reflection layer, the infrared emittance mainly depends on the selection of the material of high infrared reflective base layer and is affected by the absorbing coating. Generally, substrates or their surface employ the materials which satisfy the requirements of high infrared reflective base layers to become a part of solar energy selective absorbing coating systems.

The term "metal" means elementary metal, alloy or intermetallic-phase, unless being particularly indicated in the present application.

The term "medium" means a dielectric, particularly relating to metal compounds deposited by vacuum deposition technology that are reacted relatively completely, unless being particularly indicated in the present application.

The term "metal-medium composite material film", also being called as ceramic (phase) film, means a homogeneous composite material formed with metal micro particles and medium micro particles. The metal elements in the metal-medium composite material are present both in the form of metallic phase and in the medium. Taking a metal oxide as an example, by adjusting the flow rate of oxygen from low to high in the vacuum deposition process, the film obtained is a composition composed from metal transitional to its oxide medium. Such intermediate transition state is called as metal-medium composite material film.

Up to now, commercial solar energy heat collecting elements or solar energy selective absorbing coating systems manufactured by vacuum deposition technology in solar energy spectrum wavelength 0.3-3.0µm have generally achieved satisfying actual solar absorptance αₚ of about 0.93, and infrared emittance ε of less than 0.10. In practice, when the actual solar absorptance αₚ of solar energy selective absorbing coating systems is between 0.92 and the highest solar absorptance theoretical value α_{T} of about 0.96, the absorption effect is difficult to have actually significant change.

The process for producing solar energy heat collecting elements or solar energy selective absorbing coating systems by vacuum deposition technology comprises following steps:
(1) employing a high infrared reflective metal or a material having high infrared reflective metal surface as a substrate, or depositing the high infrared reflective metal as a metal material film onto the substrate, such as stainless steel, to form a high infrared reflective base layer;
(2) optionally depositing a buffer layeron the high infrared reflective base layer;
(3) depositing an absorbing layer on the high infrared reflective base layer or optionally present buffer, optionally generating different sublayers of absorbing layer by changing the injection flow rate of reactive gases;
(4) depositing an anti-reflection layer on the absorbing layer.

Vacuum deposition technology includes arc discharge, vacuum evaporation, and magnetron sputtering technologies. Vacuum evaporation and magnetron sputtering technologies are preferably used to manufacture solar energy heat collecting elements or solar energy selective absorbing coating systems. The dense property of the film prepared by magnetron sputtering and the adhesiveness between the film and the substrate and between the film and the film are enhanced, as compared to vacuum evaporation.

Vacuum evaporation is carried out in a vacuum chamber. The metals in an evaporating vessel or crucible are vaporized and deposited onto the substrates by electric resistance heating or electron beam bombing. If non-metal reactive gases, such as oxygen, are introduced to form reaction vacuum evaporation, then medium films or composite material films of metallic phase and its oxides can be obtained.

Magnetron sputtering technology is carried out in a vacuum chamber, e.g., as shown in Fig. 2, in which the magnetic field is vertically cross to the electric field, so that the electron moves in helix cycloid to an anode (i.e., the substrate 5). In typical theory, the electron bumps Ar atom to make Ar atom split into Ar positive ion and another free electron. Ar positive ion bombs a cathode under the action of electric and magnetic field (i.e. metal material target). The sputtered cathode metal particles are deposited onto the anode substrate 5; the sputtered secondary electron takes part in electronic movement to form self-sustained glow discharge. The electric source for magnetron sputtering can be DC electric source, pulse electric source, medium frequency AC electric source, radio frequency electric source or their combination.

Various metal material films can be obtained by non-reactive vacuum evaporation or non-reactive magnetron sputtering technologies. The non-reactive gas in the magnetron sputtering technology is Ar. Various medium films or metal-medium composite material films can be obtained by reactive vacuum evaporation and reactive magnetron sputtering technologies. Said medium is formed by said selected metals and non-metal reactive gas elements. Non-reactive gas and/or reactive gas can be injected into the vacuum chamber separately or in mixed manner, e.g., via gas inlet pipe 3, and the vacuum is maintained by means of vacuum pump. The unit sccm is employed for the injection rate of gases, namely, the injection rate per minute is calculated by gas volume based on cm³ under standard conditions. The standard conditions mean one atmospheric pressure at 25°C.

In the practice of vacuum deposition technology, technological parameters are adjusted based on the volume and shape of the vacuum chamber of specific equipments as well as the vacuum pumping efficiency and vacuum deposition power capable of being achieved so as to prepare film materials meeting the requirements. Said technological parameters mean injection rate of various gases, vacuum degree, vacuum deposition power and sputtering time. Vacuum deposition power is larger, the deposition of metal ions is rapider. Sputtering time is substantially only related to deposition thickness. When metal-medium composite material films or medium material films are deposited, if vacuum deposition power is enhanced, the injection flow rate of reactive gases should be correspondingly increased to obtain a specific ratio of metal particles to medium. However, too large power causes the reactive unstable, so that homogeneous film materials cannot be obtained. As to the same one vacuum deposition apparatus, and same specification of raw materials are used, then it is required that the films deposited under same technological parameters have same physical-chemical properties. The adjustments of technological parameters belong to conventional techniques in the art, thereby the commercial solar energy selective absorbing coating systems manufactured by vacuum deposition can achieve actual solar absorptance αₚ of 0.93, and infrared emittance ε of less than 0.10. Relevant documents include: YIN Zhiqiang and G. L. Harding, et al., "Sputtered aluminum-nitrogen solar absorbing selective surfaces for all-glass evacuated collectors", Third International Symposium on Optical and Optoelectronic Applied Sciences and Engineering, Innsbruck, Austria (1986), pp. 248; YIN Zhiqiang, "Single Cathode Sputtered Selective Solar Absorbing Surfaces", Paper Number 1148 Presented at ISES 2005 Solar World Congress in Orlando, USA. The present application cites the full contents of these documents as one part of the present application.

The composition and thickness of the optical coating prepared by vacuum deposition are determined by experiments. The normal transmission ratio spectral value T and approximately normal reflection ratio spectral value R of monolayer film material deposited by sputtering on a transparent substrate, e.g. glass or CaF₂, in the range of solar energy spectrum are measured by means of ultraviolet-visible-near infrared spectrophotometer, and the thickness Th of the film is measured by, e.g. α-step instrument. The refractive index n and extinction coefficient k are determined by computer inversion optimizing by means of the measured parameters T, R and Th based on Hadley equation. Refractive index n and extinction coefficient k are intrinsic optical characteristics of the optical films having specific proportion of components, being called optical constants. n-ik is called complex index of refraction (i is imaginary number). The n and k values determined by inversion optimizing are of multiple solutions. Hadley equation is described in L. N. Hadley and D. M. Dennison, J. Opt. Soc. Am., 37(1947) 451. The measurement and calculation of optical constants are described in detail in YIN Zhiqiang and G. L. Harding, "Optical propertiese of D. C. Reactively sputtered thin films", Thin solid Films, 120 (1984) 81-108. The present application cites the full contents of these documents as one part of the present application. The optical constants n and k values of metal-medium composite material films are between the optical constants of the metal and medium.

After the optical constants n and k values of various homogeneous film layers in the coating systems within different wavelengths are obtained by calculation, the theoretical spectral value of reflectance of various sublayers in the absorbing layer and anti-reflection layer in the solar energy selective absorbing coating systems is calculated by computer and electromagnetic equation. The average reflectance R_{TA} in the solar energy spectral range is calculated based on ISO9845-1 at air mass of 1.5, its minimum value is optimal theoretical spectral value R_{T} of reflectance in solar energy spectral range capable of being achieved by the solar energy selective absorbing coating systems, and thereby obtaining the optimal theoretical value α_{T} of absorptance of the coating systems, α_{T}=1 - R_{T}. Solar absorptance α and its calculation equation are described in detail in ISO9845-1. The present application cites the relevant contents of ISO9845-1 as one part of the present application.

Solar energy selective absorbing coating systems are manufactured based on the thicknesses of various sublayers of the absorbing layer and anti-reflection layer when optimal reflectance theoretical value is obtained, the actual reflectance spectral value Rp of the coating systems are measured by means of ultraviolet-visible-near infrared spectrophotometer, and then actual solar absorptance αₚ can be obtained by calculation based on ISO9845-1. As αₚ is less than α_{T}, this shows that changing the deposition thickness of absorbing layer and anti-reflection layer in the coating systems in small range and/or the flow rate of reactive gases in the production causes αₚ closer to α_{T}. Said adjustment belongs to a conventional process adjustment directed to the equipments specifically used.

Light selective absorbing coating can be comprised of metal-medium composite material films, wherein the total amount of metals generally accounts for 40-75 mole% of the metal-medium composite material films. The absorbing layer consists of monolayer or multilayer metal-medium composite material films respectively having uniform optical constants. With the increase of the total thickness of the absorbing layer or the number of sublayers, the amount of metal in the metal-medium composite material films preferably reduces in the direction of away from the substrate, and the optical constants correspondingly gradually vary. The absorptive property of the monolayer is poorer. Preferably the absorbing layer consists of two or three sublayers of absorbing layer having uniform optical constants respectively. The thickness of various sublayers of the absorbing layer is required to have higher transmission ratio relative to infrared ray, the inners thereof absorb energy in solar energy spectral range, and make the interfaces between various sublayers of the absorbing layer have cancellation interference effect. US patent US005523132A describes the analysis and calculation of the relationship between the layer number of absorbing layer and refractive index and cancellation interference. The present application cites the contents concerning the layer number of absorbing layer in the specification of the patent as one part of the present application. Preferably, the thickness of each sublayer is 20-100 nm, the total thickness of the absorbing layer is 50-200nm, preferably 60-150nm.

Based on desired change of the layer number of the sublayers of the absorbing layer, the ratio of metal elements in the metal-medium composite material films can vary in a large range. Taking absorptive sublayers of two layers as an example, the total amount of metal elements close to the first absorptive sublayer of the high infrared reflective layer is preferably 60-70 mole% of the first absorptive sublayer composite material films, the total amount of metal elements of the second absorptive sublayer is preferably 46-53 mole% of the second absorptive sublayer composite material films. The amount ratio of the metal elements to non metals in the metal-medium composite material films is adjusted via the flow rate of non-metal reactive gases injected into the equipments.

Due to the requirements of production technology, the change of the optical constants n and k of the absorbing layer has to be smooth relative to significant change of the flow rate of reactive gases in the production, so that an absorbing layer having uniform optical constants can be accurately prepared by adjusting the change of the flow rate of the reactive gases in the production equipments. Recently, humans have tried continuously to combine different metals or alloys with different reactive gases to find absorbing layer materials having good physical and chemical stability that are easily adjusted in production process and operation. Reactive gases are generally oxygen gas, nitrogen gas, ammonia, carbon monoxide, carbon dioxide, hydrocarbon gas or their combination. There are numerous possibilities for different metals to combine different reactive gases, since the composition of absorbing layer materials successfully obtained in practice and its relevant principle lack theoretical explanation, random screenings are carried out in seeking new materials of absorbing layers in the art.

In the prior art, elementary metals such as titanium, chromium, or alloys such as nickel chromium alloy, useful for producing absorbing layers are required to be customized, therefore the cost of raw materials is high.

CN 85100142A describes an aluminum-nitrogen/aluminum solar energy selective absorbing coating system manufactured by magnetron sputtering. The process comprises sputtering deposition of aluminum film by using single target aluminum cathode in Ar as a base layer of high infrared reflective index, reactive magnetron sputtering deposition of a composite material film of aluminum and aluminum nitride as an absorbing layer which content varies gradually in a mixed gas of Ar and active gas nitrogen, and deposition of aluminum nitride as an anti-reflection layer. The coating system is only suitable for use in vacuum environments.

DE 3522427 A1 discloses an titanium nitrogen oxygen TiNO film material as an absorbing layer of solar energy selective absorbing coating system prepared by magnetron sputtering. In the production, the electric property and physical/chemical properties including adhesiveness, corrosion resistance, thermal endurance and hardness of the film materials are controlled by adjusting the flow rate of nitrogen and oxygen. Therefore, the process is suitable for different uses.

WO9517533 further discloses a coating to converse optical energy by using vacuum evaporation deposition. The coating is represented by a formula MNₓO_{y}, wherein M is IVA group metal, preferably titanium or zirconium, x, y=0.1 to 1.7. However, micro particles of IVA group metal are poor in corrosion resistance and anti-oxidation property.

Huang Yanbin, Yin Zhiqiang and Shi Yueyan, "Optical Property Calculation of Solar Energy Selective Absorbing Surfaces", "Journal of Solar Energy",China, vol. 16, No. 2, Apr. 1995, describe the calculation results and actual measurement data of SiO₂/Mo-N-O/Mo selective absorbing surfaces, wherein Mo-N-O prepared by magnetron sputtering is used as an absorbing layer of solar energy selective absorbing coating system.

Cao Yunzhen and Hu Xingfan, "Magnetron Sputtering Ni-Cr selective absorptive film", "Journal of Solar Energy", China, vol. 20, No. 3, Jul. 1999, describe the use of NiCrNO prepared by magnetron sputtering as an absorbing layer of solar energy selective absorbing coating system.

WO01/10552 discloses a Ti-O-N film formed on a substrate by arc discharge, which is used as a light catalytic material in visible light, wherein said Ti-O-N film is regarded as intermediate phase, nitrogen atom is dispersed in the interstice of titanium oxide crystal structure.

For heat insulating glass multilayer coatings including oxynitride layers obtained by sputtering stainless steel targets in nitrogen gas and oxygen gas containing atmosphere are known from US 5 501 780 A (IIDA YASUNOBU [JP] ET AL) 26 March 1996 (1996-03-26).

### SUMMARY OF THE INVENTION

The object of the present invention is to provide a light selective absorbing coating and a production process thereof. This object is achieved by independent claims 1 and 14. Preferred embodiments are indicated in the dependent claims. The absorbing coating is easily controlled in the production process. Preferably the absorbing coating is suitable for using at high temperature in vacuum or air. Moreover, the light selective absorbing layer has a solar absorptance α of greater than 0.92.

It is surprising that the object of the present invention is achieved by formation of metal-medium composite material film with iron-chromium alloy deposited by vacuum deposition technology, preferably vacuum evaporation or magnetron sputtering and nitrogen and oxygen elements.

In the field of the production of metal-medium composite material film by vacuum deposition technology, said composite material film is usually expressed by substoichiometry, for example formula MeNO or MeNxOy, wherein x and y are stoichiometeric ratios of N and O to single metal element Me. Since the present application relates to alloys, metal-medium composite materials formed with iron chromium alloy and nitrogen and oxygen elements are expressed by formula FeCrM-N-O; tin metal nitride medium is expressed by formula SnMN, and tin metal oxynitride medium is expressed by formula SnMNO, wherein M is absent or is one or more alloying elements.

Therefore, the present invention provides a novel light selective absorbing coating, which consists of a composite material film deposited by reaction of iron chromium alloy FeCrM and non-metal gases with vacuum deposition technology, wherein said vacuum deposition technology is preferably vacuum evaporation or magnetron sputtering technology, particularly preferably magnetron sputtering technology. Based on the total weight of the alloy, iron accounts for about 60-87 wt.%, chromium accounts for about 13-25 wt.%, M is absent or is one or more alloying elements, the total amount of said metals is 40-75 mole% of the metal-medium composite material film. Said absorbing coating has a thickness of 50-200 nm, preferably 60-150 nm.

In the present invention, said non-metal gas is a mixed gas comprising oxygen gas and a nitrogen-containing gas. Said nitrogen-containing gas is nitrogen gas and/or ammonia, preferably nitrogen gas. Since nitrogen gas is a relatively inert gas, its injection rate is generally 5-20 times as much as oxygen gas. Hydrogen element in ammonia may form a hydrogen bond in composite material, the film prepared thereby may release hydrogen gas slowly when working in vacuum atmosphere thereby reducing vacuum degree. When only a mixed gas of oxygen gas and nitrogen gas is used as reactive gas, the product is FeCrM-N-O film.

In the present invention, said iron chromium alloy is preferably iron chromium nickel alloy, iron chromium nickel molybdenum alloy, iron chromium aluminum alloy or iron chromium aluminum yttrium alloy, particularly preferably austenitic stainless steel, for example, AISI 304 (OCr18Ni9) and AISI 316L (OOCr17Ni14Mo2).

The term "iron chromium alloy", unless indicated particularly in the present application, means "stainless steel", which is expressed by FeCrM, wherein, based on the total weight of alloy, iron accounts for 60-87wt.%, chromium accounts for 13-25 wt.%, M is absent or is one or more alloying elements.

Stainless steels are all iron chromium alloys and can be classified based on the structure at room temperature, including martensite type, austenitic type, ferrite and dual-phase stainless steel. Since stainless steel has excellent properties of corrosion resistance, workability, compatibility and strong toughness in very broad temperature range, it has been widely applied in heavy industry, light industry, articles of life and building and decoration fields.

In the present application, iron chromium alloy material is expressed by using steel numbers of AISI and Chinese national standard (GB1220-92, GB3280-92), for example, AISI 304 (0Cr18Ni9), AISI 316L (OOCr17Ni14Mo2). AISI 304 (0Cr18Ni9) has a chemical composition of C≤0.07 wt.%, Cr 17.0-19.0 wt.%, Ni 8.00-11.00 wt.%, Mn≤2.00 wt.%; AISI 316L (OOCr17Ni14Mo2) has a chemical composition of C≤0.03 wt.%, Cr 16.0-18.0 wt.%, Ni 12.00-15.00 wt.%, Mn≤2.00wt.%, Mo 2.00-3.00wt.%.

The stainless property and corrosion resistance of iron chromium alloy materials are attributed to chromium-rich oxide films (passive films) formed on the surface thereof. Chromium oxide of compact structure prevents diffusion of oxygen, thereby preventing oxidation of iron in the crystal cell of alloy, and greatly enhancing the capacity of anti-high temperature and anti-oxidation of iron alloy. Alloying elements endow further advantages of the prepared absorbing coating, for example, nickel and aluminum also have similar actions to reduce diffusion of iron ion and oxygen ion, nickel in relatively high content and iron chromium constitute austenitic stainless steel. Austenitic stainless steel having no magnetic property is suitable for application in magnetron sputtering technology. Micro particles of small amount of rare earth metal oxides such as Y₂O₃ can further strengthen alloys and effectively prevent the growth of high temperature crystal particles so as to prevent embrittlement of film. Said alloying elements are preferably selected from one or more of nickel, aluminum, molybdenum and yttrium.

It is surprising that the production process of metal-medium composite material films with vacuum deposition technology is easily operated and controlled when using iron chromium alloy as a metal raw material, a mixed gas of oxygen and nitrogen-containing gas as reactive gas. Hence, a composite material film of uniform optical constants can be obtained, by which the optical constants vary with slight regulation of the flow rate of reactive gas. In addition, said composite material film not only has excellent anti-high temperature property and anti-oxidation property, but also when it is used as light selective absorbing coating, the constituted light selective absorbing coating layer system has an actual solar absorptance αₚ more than 0.93. Therefore, metal-medium composite material film of iron chromium alloy can become a selection of light selective absorbing coating material. However, more prominent features lie in that the film can work at high temperature in vacuum or under air atmosphere. Moreover, stainless steel materials, as an industrial raw material widely used in the market, can be commercially available various types of stainless steel plates, tubes, and the like, without needing special production. As compared with other metal raw materials for producing light selective absorbing coatings in the prior arts, the present invention greatly reduces the cost of raw materials of solar energy selective absorbing coating system. For example, the price of the stainless steel materials is only from 1/10 to 1/20 of that of chromium nickel alloy used generally in present solar flat plate selective absorbing coating system.

In one embodiment of the present invention, reactive gas is a mixed gas comprising nitrogen gas and oxygen gas. Under the injection rate of nitrogen gas is constant, by increasing the injection rate of oxygen gas, the metal components in the metal-medium composite material film of the absorbing coating decreases in the direction away from a substrate with the increase of the thickness or the layer number of absorbing coating. The absorbing coating of the present invention can be single or multiple layer absorbing sublayers, preferably consist of two or three layers of absorbing sublayers of uniform optical constants.

In the preferred embodiments of the present invention, said absorbing layer consists of two sublayers, preferably 30-90nm of FeCrM-N-O film is deposited as a first absorptive sublayer closer to the substrate , 20-60nm of FeCrM-N-O film is deposited as a second absorptive sublayer away from the substrate , the metal content in the second absorbing sublayer is lower than that in the first absorptive sublayer.

The present invention also provides a production process of the light selective absorbing coating according to the present invention, in which the light selective absorbing coating is deposited by vacuum coating with iron chromium alloy FeCrM as a metal material to prepare the absorbing coating and a non-metal gas as reactive gas. Said vacuum deposition technology is preferably vacuum evaporation or magnetron sputtering technology, particularly preferably magnetron sputtering technology. Based on the total weight of the alloy, iron accounts for about 60-87 wt.%, chromium accounts for about 13-25 wt.%, M is absent or is one or more alloying elements. Said non-metal gas comprises a mixed gas of oxygen gas and nitrogen-containing gas, said nitrogen-containing gas is nitrogen gas and/or ammonia, preferably nitrogen gas.

In the present invention, conventional stainless steels are particularly preferably used as metal raw materials for producing light selective absorbing coating according to the present invention by vacuum deposition technology. Said stainless steels are preferably austenitic stainless steels, for example, AISI 304 (OCr18Ni9) and AISI 316L (OOCr17Ni14Mo2).

The present invention also provides use of a composite material film deposited by reaction of iron chromium alloy FeCrM and non-metal gas with vacuum deposition technology for producing solar energy heat collecting elements or light selective absorbing coatings of solar energy selective absorbing coating systems.

The present invention further provides solar energy heat collecting elements or solar energy selective absorbing coating systems, which comprise the light selective absorbing coatings of the present invention, particularly preferably FeCrM-N-O film is used as the absorbing coating.

Since the light selective absorbing coating of the present invention is constituted of metal-medium composite materials of stable physical-chemical properties, it can optionally combine with other functional layers of the solar energy selective absorbing coating system in the prior art.

In the present invention, any form of high infrared reflective substrate layers can be used, which consist of metal films having high reflective ability of infrared heat wave. High reflective property corresponds to having low infrared emittancen ε. Said metals can be selected from gold, silver, copper, aluminum, molybdenum, nickel or an alloy thereof. High infrared reflective substrate layer has a thickness which is not transparent to light, i.e., generally more than 100 nm, preferably deposition thickness is 100 -500 nm, particularly preferably 150-300 nm.

In the present invention, a buffer layer is optionally used, which consists of metal materials, preferably copper-based or molybdenum-based alloys. The buffer layeris for preventing the interdiffusion of metal atoms and migration of particles between the high infrared reflective substrate layer and the absorbing layer. The buffer layerhas a thickness of about 20 nm.

In the present invention, any form of an anti-reflection layer can be used. The anti-reflection layer is generally disposed on the surface layer of the light absorbing system, which reduces light reflection of covered layer by cancellation interference effect to enhance light absorption ratio of light absorptive system. The anti-reflection layer generally consists of a transparent medium material film, with optical refractive index n≤2.1, and a thickness in the range of mλ/4n (m is odd number), wherein A is wavelength of optical spectrum, n is refractive index, the thickness is generally between 30 and 100 nm. Thereby, the light reflection on the interface of anti-reflection layer and its reflection on the interface of the covered layer occur cancellation interference effect close to λ/2n, they cancel reflection each other so that the cancelled reflection energy enters into the covered layer. A typical anti-reflection layer is selected from silica, tin oxide, alumina (AIO), aluminum oxynitride (AINO), aluminum nitride (AIN) or MF, MCF film, wherein M is Mg, Al or nickel chromium alloy, C is carbon, F is fluorine. In practice, the metal content in the outer layer of the absorbing coating can be further reduced to form a film substantially consisting of medium as anti-reflection layer, without needing a special anti-reflection layer medium film. In the present invention, the anti-reflection layer is preferably tin-based nitride SnMN, SnMNO film, or AIO, AIN, AINO and a mixed material film thereof. They have advantages of economic costs in material and production process.

Substrate is a carrier of solar energy selective absorbing coating system, which can be strip, plate or circular pipe shape of any solid material, including metal elementary substance, alloy, inorganic material, polymeric material, and the like, wherein the alloy is, such as, galvanized low carbon steel, galvanized aluminum low carbon steel, stainless steel or heat resistant steel and the like; the inorganic material is, such as, glass, and the like. The substrate is preferably copper, aluminum or stainless steel. When the substrate 5 itself is said high infrared reflective metal or has a surface made of said high infrared reflective metal, the surface itself can be used as a high infrared reflective substrate layer of the solar energy selective absorbing coating system. The substrate is preferably constituted by copper or a stainless steel sheet on which copper film is deposited. When the substrate is a transparent glass carrier, it can be used for testing optical characteristics of the film deposited thereon.

In one embodiment of the present invention, a novel solar energy selective absorbing coating system is provided, which is prepared by deposition on a substrate by magnetron sputtering technology or vacuum evaporation technology, comprising:
1) high infrared reflective metal substrate layer;
2) optionally an buffer layer;
3) an absorbing layer, which comprises one to three layers of FeCrM-N-O film, with the increase of the thickness or the layer number of absorbing coating, the metal components in the metal-medium composite material film of the absorbing coating decreases in the direction away from the substrate, wherein the total amount of metals is 40-75 mole% of the metal-medium composite material film, the deposition thickness is 50 nm-200 nm, preferably 60 nm-150 nm;
4) an anti-reflection layer.

In preferred embodiments of the present invention, an absorbing layer and an anti-reflection layer are deposited on the substrate having high infrared reflective metal surface by magnetron sputtering technology, the substrate is preferably copper.

In one embodiment of the present invention, a solar energy heat collecting element is produced, wherein the substrate has a high infrared reflective metal surface, such as gold, silver, copper, aluminum, molybdenum or nickel surface, the surface is used as or substituted for the high infrared reflective substrate layer of said solar selective absorbing coating system so as to become a part of solar energy selective absorbing coating system.

In the preferred embodiments of the present invention, metal copper is deposited on the substrate as a high infrared reflective substrate layer by magnetron sputtering technology in non-reactive gas Ar with metal copper as a cathode (target); FeCrM-N-O film is deposited on the surface of copper as a first absorptive sublayer by injecting reactive gases nitrogen and oxygen with conventional commercial austenitic stainless steel, such as AISI 304 (OCr18Ni9) or AISI 316L (00Cr17Ni14Mo2) as cathode (target), and then FeCrM-N-O film is deposited as a second absorptive sublayer by increasing oxygen injection rate, thereby, the second absorptive sublayer has lower iron chromium alloy content than the first absorptive sublayer; a film of tin metal nitride SnN, tin metal oxynitride SnNO, and a mixed material thereof is deposited on the absorbing layer with metal tin as a cathode (target) by regulating the injection rates of nitrogen gas and oxygen gas, or a film of AIO, AIN, AINO and a mixed material thereof is deposited with metal aluminum as a cathode (target), the deposition thickness is 30-1 00nm.

In particularly preferred embodiments of the present invention, FeCrM-N-O (1) film with a thickness of 30-90 nm is deposited as a first absorptive sublayer on the substrate having copper surface by magnetron sputtering technology by directly injecting reactive gases nitrogen and oxygen with AISI 304 (OCr18Ni9) or AISI 316L (00Cr17Ni14Mo2) as cathode (target), and then FeCrM-N-O (2) film with a thickness of 20-60 nm is deposited as a second absorptive sublayer, and at last SnNO or SnN film with a thickness of 30-100nm is deposited as an anti-reflection layer with metal tin as cathode (target).

### ANALYSIS OF COMPONENTS

The atomic ratio of each element in single layer of film material can be determined by Auger electron spectroscopy (AES) analysis

AES analysis is a micro-area surface analytic technology and widely applied in many scientific fields of surface physics, chemistry, metallurgy, and semiconductor relating to surface and interface. The simple principle of this method is: a sample to be analyzed is placed in a 10⁻⁹ Torr ultrahigh vacuum chamber, bombarded with electron beam having energy of from hundreds to thousands of electron volts to electroionize the atoms on the surface layer. During relaxation balance, excited atoms may radiate X ray having characteristic wavelengths of elements and emit an Auger electron having characteristic energy of elements. The distribution of relative electron numbers emitted from the sample surface with energy change is recorded, namely, N(E)-E curve, or the distribution of the derivative of relative electron numbers to energy with energy change is recorded, namely, dN(E)/dE-E curve, and then the positions, shapes and strengths of the characteristics energy peaks of Auger electrons on such curves are analyzed to obtain the components of atoms on the surface layer and their amounts. In the present application, PH1 700 scanning Auger nano-probe is used.

The components of alloy materials are expressed by weight percent. It is mole (atomic number) percent directly provided by AES analysis.

### DESCRIPTION OF THE DRAWINGS

Fig. 1 shows solar selective absorbing coating system, which is a structure of multiple layers, on the substrate 5 of, e.g. strip shape or circular pipe shape, there are, in turn, high infrared reflective base layer 1, buffer layer 2, absorbing layer 3 and anti-reflection layer 4.
Fig. 2 is schematic diagram of vacuum chamber of planar magnetron sputtering coating machine.
Fig. 3a shows spectral values of optical constants n, k of first absorptive sublayer material FeCr17Ni14Mo2-N-O (1), deposition thickness is 20 nm, and abscissa is spectral wavelength.
Fig. 3b shows spectral values of optical constants n, k of second absorptive sublayer material FeCr17Ni14Mo2-N-O (2), deposition thickness is 72 nm, in which the amount of metals lower than that of FeCr17Ni14Mo2-N-O(1),and abscissa is spectral wavelength.
Fig. 4a shows full spectrum of Auger analysis of FeCr17Ni14Mo2-N-O (1).
Fig. 4b shows full spectrum of Auger analysis of FeCr17Ni14Mo2-N-O (1).
Fig. 5 shows a comparison between theoretical value R_{T} of the spectral value of reflectance of light selective absorbing coating of Cu/FeCr17Ni14Mo2-N-O (1)/FeCr17Ni14Mo2-N-O (2)/SnNO coating system and actual measurement value Rp (R_{T} is expressed by solidline curve, Rp is expressed by dotted line), and the abscissa is spectral wavelength.
Fig. 6a shows spectral values of optical constants n, k of first absorptive sublayer material FeCr18Ni9-N-O (1), deposition thickness is 21 nm, and abscissa is spectral wavelength.
Fig. 6b shows spectral values of optical constants n, k of second absorptive sublayer material FeCr18Ni9-N-O (2), deposition thickness is 66 nm, in which the amount of metals lower than that of FeCr18Ni9-N-O (1),and abscissa is spectral wavelength.
Fig. 7a shows full spectrum of Auger analysis of FeCr18Ni9-N-O (1).
Fig. 7b shows full spectrum of Auger analysis of FeCr18Ni9-N-O (2).
Fig. 8 shows actual measurement value Rp of the spectral value of reflectance of light selective absorbing coating of Cu/ FeCr18Ni9-N-O (1)/FeCr18Ni9-N-O (2)/SnNO coating system, and the abscissa is spectral wavelength.

### EMBODIMENTS

### Example 1: Magnetron sputtering deposition of AISI 316L (00Cr17Ni14Mo2) oxynitride composite material film at low power and measurement and calculation of optical constants thereof

In vacuum chamber of planar magnetron sputtering coating machine as shown in Fig. 2, the magnetron sputtering chamber had a volume of about 0.1 m³, in which AISI 316L (OOCr17Ni14Mo2) iron chromium alloy target 1 was disposed at the upper part therein, with the target facing downward; a glass substrate 5 with a dimension of 25mm x 38mm x 1 mm was mounted in the substrate frame 4, the distance between the target and the substrate was 70 mm; a gas inlet pipe 3 was mounted about the target, a gas or a mixed gas was injected, respectively; the sputtering chamber wall and the substrate were used as anode isoelectric potential and grounded; permanent magnetic circuit was used for two plane targets, a magnetic field vertical to electric field was generated on the surface of target cathode to constitute electric and magnetic conditions for magnetron sputtering, in the magnetic circuit there were cooling liquid, preferably softened water. The magnetron sputtering chamber was vacuumed into low vacuum and then high vacuum to 10⁻³ Pa by using a mechanical pump. The conductance between the sputtering chamber and the high vacuum pump was regulated by a throttle valve.

A flow rate of 10 sccm of Ar was injected through the gas inlet pipe 3 into the sputtering chamber to make the pressure of the sputtering chamber be 0.4 Pa, and 10 sccm of nitrogen gas and 1.0 sccm of oxygen gas were injected into the chamber. The direct current sputtering power was 100W. The sputtering was carried out for 2 minutes. The thickness of film was measured by means of α-Step instrument. FeCr17Nil4Mo2-N-O (1) film with a deposition thickness of 20 nm was obtained.

Under the conditions of above equipments, only the injection rate of oxygen gas was regulated to 2.0 sccm. The sputtering was carried out for 12 minutes. The thickness of film was measured by means of α-Step instrument. FeCr17Ni14Mo2-N-O (2) film with a deposition thickness of 72 nm was obtained.

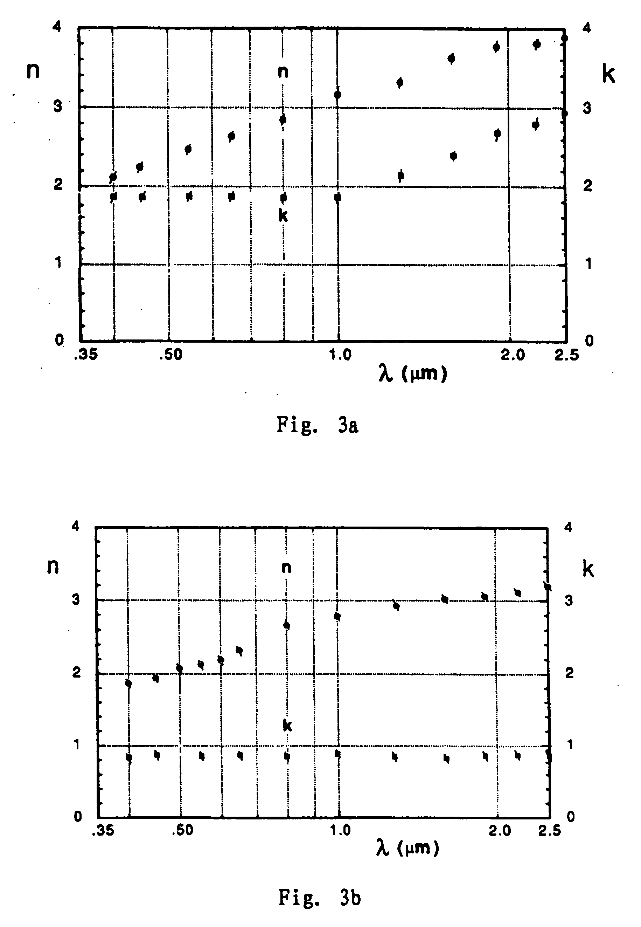

The spectral value R (incident at 15°) of the normal transmission ratio and reflection ratio of the film obtained in the range of 0.35-2.5 µm was measured by PE Lambda 9 spectrophotometer. The optical constants n and k of FeCr17Ni14Mo2-N-O (1) and FeCr17Ni14Mo2-N-O (2) films were determined by computer inversion optimizing based on Hadley equation. The results were shown in Figs. 3a and 3b.

### Example 2: Magnetron sputtering deposition of AISI 316L (OOCr17Ni14Mo2) oxynitride composite material film at large power and measurement and calculation of optical constants thereof

Under the conditions of the equipments as shown in Fig. 2 identical to those in Example 1, the direct current sputtering power was set at about 5kW. The injection rate of gases was tried to increase. After conventional adjustments, a composite material film having closest optical constants to that of Example 1 was obtained under following technological parameters.

A flow rate of 35 sccm of Ar was injected through the gas inlet pipe 3 into the sputtering chamber to make the pressure of the sputtering chamber be 0.4 Pa, and 150 sccm of nitrogen gas and 15 sccm of oxygen gas were injected into the chamber. The direct current sputtering power was 5.17 kW. The sputtering was carried out for 40 seconds. The thickness of film was measured by means of α-Step instrument. FeCr17Ni14Mo2-N-O (1) film with a deposition thickness of 20 nm was obtained.

Under the conditions of above equipments, only the injection rate of oxygen gas was regulated to 19 sccm. The direct current sputtering power was 5.09 kW. The sputtering was carried out for 3 minutes. The thickness of film was measured by means of α-Step instrument. FeCr17Ni14Mo2-N-O (2) film with a deposition thickness of 72 nm was obtained.

The spectral value R (incident at 15°) of the normal transmission ratio and reflection ratio of the film obtained in the range of 0.35-2.5 µm was measured by PE Lambda 9 spectrophotometer. The optical constants n and k of FeCr17Ni14Mo2-N-O (1) and FeCr17Ni14Mo2-N-O (2) films were determined by computer inversion optimizing based on Hadley equation. The results had no substantive difference from those in Example 1.

The components of FeCr17Ni14Mo2-N-O (1) and FeCr17Ni14Mo2-N-O (2) prepared in Example 2 were analyzed by means of Auger nano-probe.

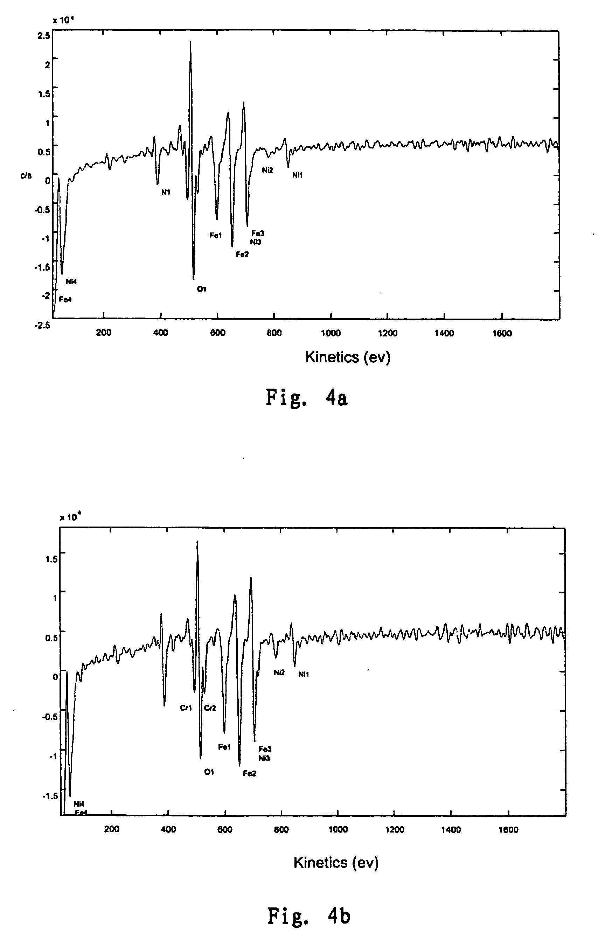

**Table 1: Atomic mole percent of absorbing layer (Fig. 4a and Fig. 4b)**

| Element components (mol%) | Fe | Cr | Ni | Mo | N | O |
|---|---|---|---|---|---|---|
| FeCr17Ni14Mo2-N-O (1) | 52.7 | 8.6 | 10.7 | 1.0 | 18.7 | 11.5 |
| FeCr17Ni14Mo2-N-O (2) | 49.8 | 8.6 | 8.7 | 0.5 | 11.6 | 24.3 |

### Example 3: Deposition of FeCr17Ni14Mo2-N-O/SnNO solar energy selective absorbing coating system on the substrate to prepare solar energy heat collecting element

Copper sheet as the substrate 5 was mounted on the substrate frame of planar magnetron sputtering plating machine as shown above in Fig. 2. The magnetron sputtering chamber had a volume of about 0.1 m³, in which AISI 316L (00Cr17Ni14Mo2) alloy target 1 and Sn target 2 were installed at the upper part therein, with the targets facing downward. The distance between the targets and the substrate was 70 mm. The magnetron sputtering chamber was vacuumed into low vacuum and then high vacuum to 10⁻³ Pa by using a mechanical pump. The conductance between the sputtering chamber and the high vacuum pump was regulated by a throttle valve.

A flow rate of 35 sccm of Ar was injected through the gas inlet pipe 3 into the sputtering chamber to make the pressure of the sputtering chamber be 0.4 Pa, and 150 sccm of nitrogen gas and 15 sccm of oxygen gas were injected into the chamber. The direct current sputtering power was 5.17 kW. The sputtering was carried out for 1 minute 40 seconds. FeCr17Ni14Mo2-N-O (1) film with a deposition thickness of 50 nm was prepared as a first absorbing sublayer.

The injection rate of oxygen gas was regulated to 19 sccm. The direct current sputtering power was 5.09 kW. The sputtering was carried out for 1 minute 20 seconds. FeCr17Ni14Mo2-N-O (2) film with a deposition thickness of 32 nm was prepared as a second absorbing sublayer.

The flow rate of nitrogen gas was regulated to 66 sccm and the flow rate of oxygen gas was regulated to 34 sccm (free of Ar). The direct current sputtering power was 1.26 kW. The sputtering was carried out on Sn target for 3 minutes. SnNO medium film with a deposition thickness of 45 nm was prepared.

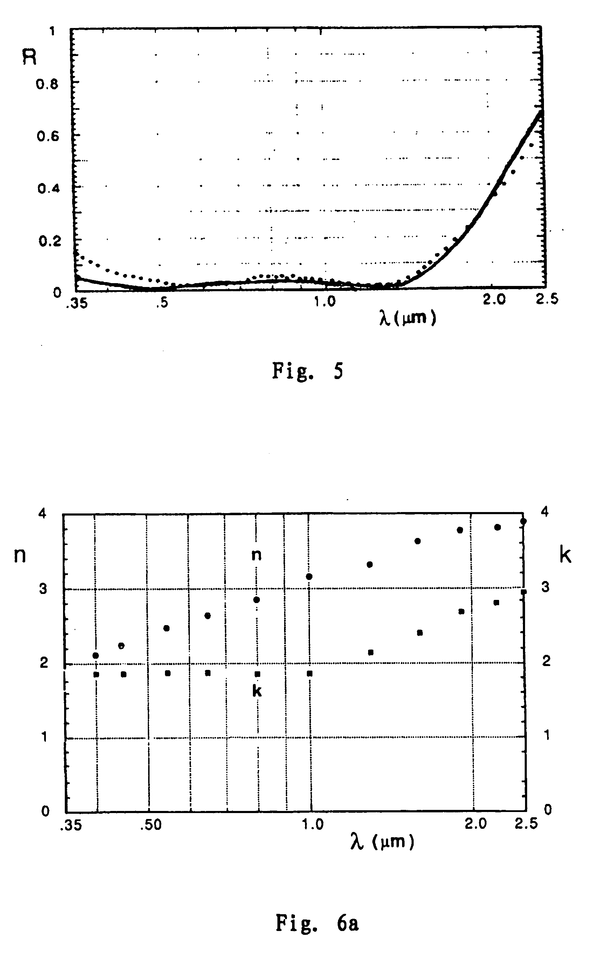

The spectral value R (incident at 15°) of the reflection ratio of the prepared solar energy selective absorbing coating system in solar energy spectral range of 0.35-2.5 µm was measured by Beckman ACTA MVII spectrophotometer with an integrating sphere. The results were as shown in Fig. 5. The solar energy absorption ratio αₚ of the coating system was 0.93, by calculation. The spectral value R of the reflection ratio of the prepared solar energy selective absorbing coating system in solar energy spectral range of 2.5-25 µm was measured by Perkin Elmer 580B spectrophotometer. The infrared emittance ε of the coating system was 0.07, by calculation.

The solar energy selective absorbing coating sample of SnNO/FeCr17Ni14Mo2-N-O /copper substrate was heated in air to 250□ and held for 50 hours, the solar energy absorption ratio and the infrared emittance of the coating had no obvious changes.

### Example 4: Magnetron sputtering deposition of AISI 304 (OCr18Ni9) oxynitride composite material film and measurement and calculation of optical constants thereof

A glass substrate 5 with a dimension of 25mm x 38mm x 1 mm was mounted in the substrate frame 4 of the planar magnetron sputtering plating machine as shown above in Fig. 2. The magnetron sputtering chamber had a volume of about 0.1 m³, in which AISI 304 (OCr18Ni9) iron chromium alloy target 1 was installed at the upper part therein, with the target facing downward; the distance between the target and the substrate was 70 mm; The magnetron sputtering chamber was vacuumed into low vacuum and then high vacuum to 10⁻³ Pa by using a mechanical pump. The conductance between the sputtering chamber and the high vacuum pump was regulated by a throttle valve.

A flow rate of 35 sccm of Ar was injected through the gas inlet pipe 3 into the sputtering chamber to make the pressure of the sputtering chamber be 0.4 Pa, and 120 sccm of nitrogen gas and 8 sccm of oxygen gas were injected into the chamber. The direct current sputtering power was 5.15kW. The sputtering was carried out for 45 seconds. The thickness of film was measured by means of α-Step instrument. FeCr18Ni9-N-O (1) film with a deposition thickness of 21 nm was obtained.

Under the conditions of above equipments, only the injection rate of oxygen gas was regulated to 12 sccm. The sputtering was carried out for 3 minutes. The thickness of film was measured by means of α-Step instrument. FeCr18Ni9-N-O (2) film with a deposition thickness of 66 nm was obtained.

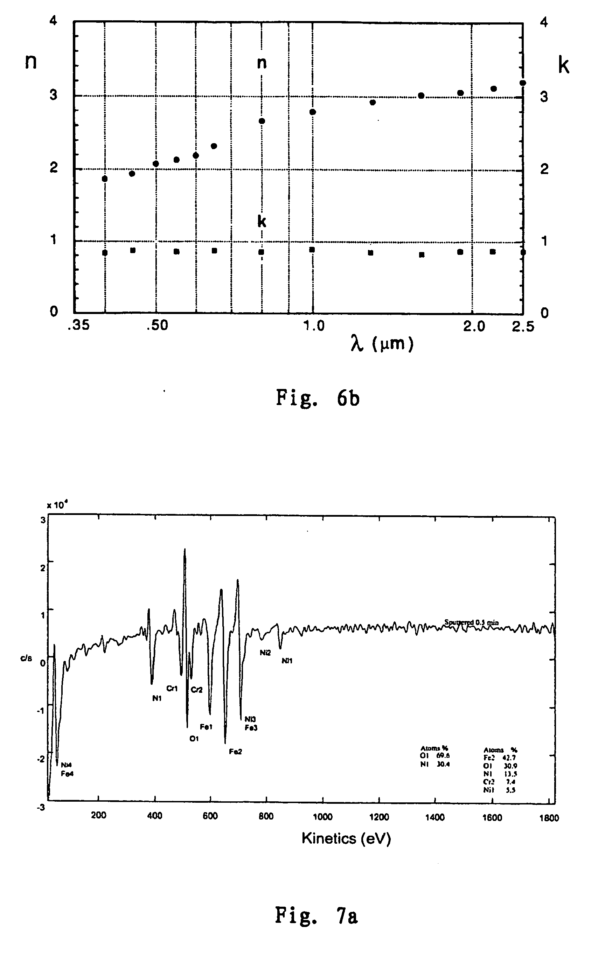

The spectral value R (incident at 15°) of the normal transmission ratio and reflection ratio of the film obtained in the range of 0.35-2.5 µm was measured by PE Lambda 9 spectrophotometer. The optical constants n and k of FeCr18Ni9-N-O (1) and FeCr18Ni9-N-O (2) films were determined by computer inversion optimizing based on Hadley equation. The results were very close to those of the films prepared in Example 1, shown in Figs. 6a and 6b.

The components of FeCr18Ni9-N-O (1) and FeCr18Ni9-N-O (2) were analyzed by means of Auger nano-probe.

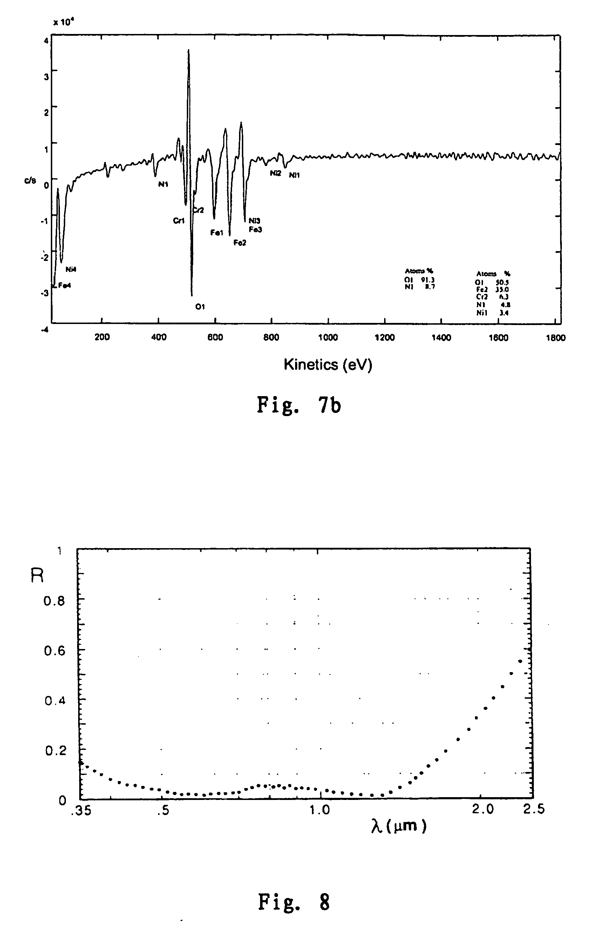

**Table 2: Atomic mole percent of absorbing layer (Fig. 7a and Fig. 7b)**

| Element components (mol%) | Fe | Cr | Ni | N | O |
|---|---|---|---|---|---|
| FeCr18Ni9-N-O (1) | 42.7 | 7.4 | 5.5 | 13.5 | 30.9 |
| FeCr18Ni9-N-O (2) | 35.0 | 6.3 | 3.4 | 4.8 | 50.5 |

### Example 5: Deposition of FeCr18Ni9-N-O/SnNO solar energy selective absorbing coating system on the copper substrate to prepare solar energy heat collecting elements

Copper sheet as the substrate 5 was mounted on the substrate frame of planar magnetron sputtering plating machine as shown above in Fig. 2. The magnetron sputtering chamber had a volume of about 0.1 m³, in which FeCr18Ni9 alloy target 1 (AISI 304 (0Cr18Ni9)) and Sn target 2 were installed at the upper part therein, with the targets facing downward. The distance between the targets and the substrate was 70 mm. The magnetron sputtering chamber was vacuumed into low vacuum and then high vacuum to 10⁻³ Pa by using a mechanical pump. The conductance between the sputtering chamber and the high vacuum pump was regulated by a throttle valve.

A flow rate of 35 sccm of Ar was injected through the gas inlet pipe 3 into the sputtering chamber to make the pressure of the sputtering chamber be 0.4 Pa, and 120 sccm of nitrogen gas and 8 sccm of oxygen gas were injected into the chamber. The direct current sputtering power was 5.15 kW. The sputtering was carried out for 2 minutes. FeCr18Ni9-N-O (1) film with a deposition thickness of 56 nm was prepared as a first absorptive sublayer.

The injection rate of oxygen gas was regulated to 12 sccm. The sputtering was carried out for 1 minute 45 seconds. FeCr18Ni9-N-O (2) film with a deposition thickness of 39 nm was prepared as a second absorptive sublayer.

The flow rate of nitrogen gas was regulated to 66 sccm nd the flow rate of oxygen gas was regulated to 34 sccm (free of Ar). The direct current sputtering power was 1.26 kW. The sputtering was carried out on Sn target for 3 minutes. SnNO medium film with a deposition thickness of 45 nm was prepared.

The spectral value R (incident at 15°) of the reflection ratio of the prepared solar energy selective absorbing coating system in solar energy spectral range of 0.35-2.5 µm was measured by Beckman ACTA MVII spectrophotometer with an integrating sphere. The results were as shown in Fig. 8. The solar energy absorption ratio αₚ of the coating system was 0.93, by calculation. The spectral value R of the reflection ratio of the prepared solar energy selective absorbing coating system in infrared spectral range of 2.5-25 µm was measured by Perkin Elmer 580B spectrophotometer. The infrared emittance ε of the coating system was 0.06, by calculation.

The solar energy selective absorbing coating sample of SnNO/FeCr18Ni9-N-O /copper substrate was heated in air to 250°C and held for 50 hours, the solar energy absorption ratio and the infrared emittance of the coating had no obvious changes.

Conclusion: the solar energy selective absorbing coating system consisting of FeCrM-N-O composite material film as absorbing layer can achieve the solar energy absorption ratio α of high quality of the same class of the products. Therefore, a novel selective solar energy heat collecting element is provided.

## Claims

1. A light selective absorbing coating consisting of a composite material film formed with vacuum deposition technology on a substrate by a reaction of an iron chromium alloy and a non metal gas comprising oxygen and nitrogen gas, whereby in the alloy, based on the total weight of the alloy, iron accounts for 60-87 wt.%, chromium accounts for 13-25 wt.%, M is absent or is one or more alloying elements, the total amount of said metals is 40-75 mole% **characterized in that** the amount of metal in the metal-medium composite material film of the absorbing coating expressed as FeCrM-N-O decreases in the direction away from the substrate.

2. The light selective absorbing coating according to claim 1, wherein the iron chromium alloy is austenitic stainless steel.

3. The light selective absorbing coating according to claim 2, wherein the iron chromium alloy is AISI 304 (0Cr18Ni9) or AISI 316L (00Cr17Ni14Mo2).

4. The light selective absorbing coating according to claim 1, **characterized in that** said alloying elements are selected from one or more of nickel, aluminum, molybdenum and yttrium.

5. The light selective absorbing coating according to claim 1, **characterized in that** the total thickness of the absorbing coating is 50-200 nm.

6. The light selective absorbing coating according to claim5, wherein the total thickness of the absorbing coating is 60-150 nm.

7. The light selective absorbing coating according to claim 5, **characterized in that** the absorbing layer consists of two sublayers

8. The light selective absorbing coating according to claim 5, **characterized in that** 30-90nm of FeCrM-N-O film is deposited as a first absorptive sublayer closer to the substrate, 20-60nm of FeCrM-N-O film is deposited as a second absorptive sublayer away from the substrate, the metal content in the second absorptive sublayer is lower than that in the first absorptive sublayer.

9. The light selective absorbing coating according to any of claims 1 to 8, **characterized in that**, said vacuum deposition technology is magnetron sputtering technology.

10. A solar energy heat collecting element or solar energy selective absorbing coating system comprising a light selective absorbing coating as claimed in any of claims 1 to 9.

11. The solar energy heat collecting element or solar energy selective absorbing coating system according to claim 10, which further comprises a high infrared reflective base layer (1) deposited on the surface of a substrate (5), optionally a buffer layer (2) and an anti-reflection layer (4)

12. The solar energy heat collecting element or solar energy selective absorbing coating system according to claim 11, wherein the surface of the substrate (5) or high infrared reflective layer consists of copper, aluminum, molybdenum, nickel or an alloy thereof, the anti-reflection layer consists of 40-60 nm of tin-based nitride SnMN, SnMNO film, or AIO, AIN, AINO and a mixed material film thereof, wherein M is absent or is one or more alloying elements.

13. The solar energy heat collecting element or solar energy selective absorbing coating system according to claim 12, wherein the substrate (5) is copper material or a copper film-deposited stainless steel material.

14. A process for producing a light selective absorbing coating according to any of claims 1 to 9 with iron chromium alloy material as metal raw material, wherein the light selective absorbing coating is deposited by vacuum deposition technology with a non-metal gas as a reactive gas, said iron chromium alloy is expressed by FeCrM, based on the total weight of alloy, iron accounts for 60-87wt.%, chromium accounts for 13-25 wt.%, M is absent or is one or more alloying elements, said non-metal gas comprises a mixed gas of oxygen gas and nitrogen-containing gas, said nitrogen-containing gas is nitrogen gas and/or ammonia.

15. The process according to claim 14, **characterized in that** said nitrogen-containing gas is nitrogen gas.

16. The process according to claim 14 or 15, **characterized in that** under the circumstance that the injection rate of nitrogen gas is constant, a composite material film having specific optical constants is prepared by adjusting partial pressure of oxygen gas.

## Patentansprüche

1. Eine Licht selektiv absorbierende Beschichtung bestehend aus einem CompositMaterialfilm, der durch Vakuumablagerung auf ein Substrat durch eine Reaktion einer Eisenchromlegierung und eines nichtmetallischen Gases, das Sauerstoff und Stickstoff enthält, gebildet ist, wobei die Menge an Eisen zwischen 60 und 87 Gew% und die Menge an Chrom zwischen 13 und 25 Gew% der Legierung, basierend auf dem Gesamtgewicht der Legierung, beträgt, M fehlt oder in einem oder mehreren der Legierungselemente vorhanden ist, und die Gesamtmenge des Metalls 40 bis 75 mol% beträgt, **dadurch gekennzeichnet, dass** die Menge des Metalls in dem Metallmedium-Compositmaterialfilm der absorbierenden Beschichtung ausgedrückt als FeCrM-N-O in Richtung weg von dem Substrat abnimmt.

2. Die Licht selektiv absorbierende Beschichtung nach Anspruch 1, wobei die Eisenchromlegierung austenitischer Edelstahl ist.

3. Die Licht selektive Absorptionsschicht nach Anspruch 2, wobei die Eisenchromlegierung AlSI 304 (0Cr18Ni9) oder AlSI 316L (00Cr17Ni14Mo2) ist.

4. Die Licht selektiv absorbierende Beschichtung nach Anspruch 1, **dadurch gekennzeichnet, dass** die Legierungselemente ausgewählt sind aus Nickel und/oder Aluminium und/oder Molybdän und/oder Yttrium.

5. Die Licht selektiv absorbierende Beschichtung nach Anspruch 1, **dadurch gekennzeichnet, dass** die Gesamtdicke der absorbierenden Beschichtung 50 bis 200 nm beträgt.

6. Die Licht selektiv absorbierende Beschichtung nach Anspruch 5, wobei die Gesamtdicke der absorbierenden Beschichtung 50 bis 150 nm beträgt.

7. Die Licht selektiv absorbierende Beschichtung nach Anspruch 5, **dadurch gekennzeichnet, dass** die absorbierende Schicht aus zwei Unterschichten besteht.

8. Die Licht selektiv absorbierende Beschichtung nach Anspruch 5, **dadurch gekennzeichnet, dass** 30 bis 90 nm eines FeCrM-N-O-Films als eine erste Absorptionsunterschicht näher zu dem Substrat angeordnet wird, 20 bis 60 nm eines FeCrM-N-O-Films als eine zweite absorbierende Unterschicht weiter weg von dem Substrat angeordnet ist, wobei der Metallgehalt der zweiten absorbierenden Unterschicht geringer ist als diejenige der ersten absorbierenden Unterschicht.

9. Die Licht selektiv absorbierende Beschichtung nach einem der Ansprüche 1-8, **dadurch gekennzeichnet, dass** die Vakuumablagerung eine Magnetron-Sputter-Technologie ist.

10. Ein Solarkollektorelement oder ein Solarenergie selektiv absorbierendes Beschichtungssystem mit einer Licht selektiven Absorptionsbeschichtung nach den Ansprüchen 1-9.

11. Das Solarkollektorelement oder das Solarenergie selektiv absorbierende Beschichtungssystem nach Anspruch 10, weiter mit einer für Infrarotlicht hoch reflektierende Basisschicht (1), die auf der Fläche eines Substrats (5), optional einer Pufferschicht (2) und einer Anti-Reflexionsschicht (4), abgelagert ist.

12. Das Solarkollektorelement oder das Solarenergie selektiv absorbierende Beschichtungssystem nach Anspruch 11, wobei die Fläche des Substrats (5) oder die Infrarotlicht stark reflektierende Schicht aus Kupfer, Aluminium, Molybdän, Nickel oder einer Legierung daraus besteht und die Antireflexionsschicht aus 40-60 nm eines auf Zinn basierenden Nitrids SnMN, SnMNO Film oder aus AlO, AlN, AlNO und einem aus diesem Materialien gemischten Film besteht, wobei M fehlt oder in einem oder mehreren der Legierungselemente vorhanden ist.

13. Das Solarkollektorelement oder das Solarenergie selektiv absorbierende Beschichtungssystem nach Anspruch 12, wobei das Substrat (5) Kupfermaterial oder ein Edelstahlmaterial, auf dem einem Kupferfilm abgelagert ist, ist.

14. Ein Verfahren zum Herstellen einer Licht selektiv absorbierenden Beschichtung nach einem der Ansprüche 1-9, mit einem Eisenchromlegierungsmaterial als unbearbeitetes Metall, wobei die Licht selektierende Absorptionsbeschichtung durch Vakuumablagerung mit einem nicht-metallischen Gas als Reaktionsgas abgelagert wird, wobei die Eisenchromlegierung durch FeCrM ausgedrückt wird, und wobei, basierend auf dem Gesamtgewicht der Legierung, Eisen in einer Menge von 60-87 w%, Chrom in einer Menge von 13-25 w% vorhanden ist, M fehlt oder in einem oder mehreren der Legierungselemente vorhanden ist, wobei das nicht-metallische Gas ein Mischgas aus einem Sauerstoffgas und einem Stickstoff beinhaltenden Gas ist, wobei das Stickstoff beinhaltende Gas ein Stickstoffgas und/oder Ammoniakgas ist.

15. Das Verfahren nach Anspruch 14, **dadurch gekennzeichnet, dass** das Stickstoff beinhaltende Gas Stickstoffgas ist.

16. Das Verfahren nach Anspruch 14 oder 15, **dadurch gekennzeichnet, dass** dann, wenn die Injektionsrate des Stickstoffgases konstant ist, ein Compositmaterialfilm mit bestimmten optischen Konstanten durch Justieren des Partialdrucks des Sauerstoffgases hergestellt wird.

## Revendications

1. Revêtement capable d'absorber sélectivement de la lumière constitué d'un film de matériau composite formé avec la technologie de dépôt sous vide sur un substrat par une réaction d'un alliage fer-chrome et d'un gaz non métallique contenant du gaz oxygène et du gaz azote, si bien que dans l'alliage, sur la base du poids total de l'alliage, le fer rend compte d'environ 60 à 87 % en poids, le chrome rend compte de 13 à 25% en poids, M est absent ou représente l'un ou plusieurs éléments d'alliage, la quantité totale desdits métaux étant de 40 à 75 mole %, **caractérisé en ce que** la quantité de métal dans le film de matériau composite du moyen métallique du revêtement absorbant exprimé en tant que FrCrM-N-O diminue dans la direction opposée du substrat.

2. Revêtement capable d'absorber sélectivement de la lumière selon la revendication 1, dans lequel l' alliage fer-chrome est de l'acier inoxydable austénitique.

3. Revêtement capable d'absorber sélectivement de la lumière selon la revendication 2, dans lequel l'alliage fer-chrome est AISI 304 (0Cr18Ni9) ou AISI 316L (OOCr17Ni14Mo2).

4. Revêtement capable d'absorber sélectivement de la lumière selon la revendication 1, **caractérisé en ce que** les éléments d'alliage sont sélectionnés parmi un ou plusieurs éléments constitués de nickel, aluminium, molybdène et yttrium.

5. Revêtement capable d'absorber sélectivement de la lumière selon la revendication 1, **caractérisé en ce que** l'épaisseur totale du revêtement absorbant est de 50 à 200 nm.

6. Revêtement capable d'absorber sélectivement de la lumière selon la revendication 5, dans lequel l'épaisseur totale du revêtement absorbant est de 60 à 150 nm.

7. Revêtement capable d'absorber sélectivement de la lumière selon la revendication 5, **caractérisé en ce que** la couche absorbante est constituée de deux sous-couches.

8. Revêtement capable d'absorber sélectivement de la lumière selon la revendication 5, **caractérisé en ce que** 30 à 90 nm du film de FeCrM-N-O est déposé en tant que première sous-couche d'absorption plus près du substrat, 20 à 60 nm du film de FeCrM-N-O est déposé en tant que deuxième sous-couche dans la direction opposée du substrat, la teneur en métal dans la deuxième sous-couche d'absorption étant plus basse que celle contenue dans la première couche d'absorption.

9. Revêtement capable d'absorber sélectivement de la lumière selon l'une quelconque des revendications 1 à 8, **caractérisé en ce que** ladite technologie de dépôt sous vide est une technologie de pulvérisation au magnétron.

10. Élément de collecte de la chaleur de l'énergie solaire ou système de revêtement capable d'absorber sélectivement l'énergie solaire comprenant un revêtement capable d'absorber sélectivement de la lumière selon le procédé de l'une quelconque des revendications 1 à 9.

11. Élément de collecte de la chaleur de l'énergie solaire ou système de revêtement capable d'absorber sélectivement l'énergie solaire selon la revendication 10, qui comprend en outre une couche de base à forte réflexion du rayonnement infrarouge (1) déposée sur la surface d'un substrat (5), éventuellement une couche intermédiaire (2) et une couche anti-réflexion (4).

12. Élément de collecte de la chaleur de l'énergie solaire ou système de revêtement capable d'absorber sélectivement l'énergie solaire selon la revendication 11, dans lequel la surface du substrat (5) ou la couche à forte réflexion du rayonnement infrarouge est constituée de cuivre, d'aluminium, de molybdène, de nickel ou d'un alliage de ceux-ci, la couche anti-réflexion étant constituée de 40 à 60 nm de nitrure à base d'étain SnMN, d'un film de SnMNO ou de AIO, AIN, AINO et d'un film de matériaux mélangés à partir de ceux-ci, dans lequel M est absent ou représente un ou plusieurs éléments d'alliage.

13. Élément de collecte de la chaleur de l'énergie solaire ou système de revêtement capable d'absorber sélectivement l'énergie solaire selon la revendication 12, dans lequel le substrat (5) est un matériau de cuivre ou un matériau d'acier inoxydable déposé sur un film de cuivre.

14. Procédé de production d'un revêtement capable d'absorber sélectivement la lumière selon l'une quelconque des revendications 1 à 9, avec un matériau d'alliage fer-chrome en tant que matière première, dans lequel le revêtement capable d'absorber sélectivement la lumière est déposé par la technologie de dépôt sous vide avec un gaz non métallique en tant que gaz réactif, ledit alliage fer-chrome étant exprimé par FeCrM, sur la base du poids total de l'alliage, le fer rendant compte de 60 à 87 % en poids, le chrome rendant compte de 13 à 25% en poids, M étant absent ou représentant un ou plusieurs éléments d'alliage, ledit gaz non métallique contenant un gaz mélangé de gaz oxygène et de gaz contenant de l'azote, ledit gaz contenant de l'azote étant un gaz azote et/ou de l'ammoniac.

15. Procédé selon la revendication 14, **caractérisé en ce que** ledit gaz contenant de l'azote est un gaz azote.

16. Procédé selon la revendication 14 ou 15, **caractérisé en ce que** dans la circonstance où la vitesse d'injection du gaz azote est constante, un film de matériau composite présentant des constantes optiques spécifiques est préparé par l'ajustement de la pression partielle du gaz oxygène.
